# EUROPEAN PATENT APPLICATION

(11) **EP 0 632 467 A1**
(43) Date of publication of application: **04.01.1995**
(21) Application number: 93480083.0
(22) Date of filing: 30.06.1993
(51) Int. Cl.: G11C 29/00

(54) **Integrated circuit with a processor-based abist circuit**

(71) Applicant: International Business Machines Corporation, Armonk, N.Y. 10504 (US)
(72) Inventor: Rapoport, Stuart, Washington, DC 20016 (US)
(74) Representative: Klein, Daniel Jacques Henri

(57) **Abstract**

There is described a novel processor-based ABIST circuit (20) that generates self-test patterns for high speed SRAM macros with short access and system cycle times. It is comprised of three main blocks. First, a conventional address generator block (20-A) to generate the CNOOP, STADD, STBA0E and STWA0E signals. The two latter signals are used in the control logic main block (20-B), which generates four control signals TS0, TS1 and their complements CTS0, CTS1. These control signals are determined by the type of test patterns and the ABIST cycle. The role of the control logic main block (20-B) is to force a proper signal sequencing of the processing main block (20-C) during the ABIST mode. Processing main block (20-C) has the key role of generating the STDATA, the EXDATA, and the STRW signals, in response to the said control signals. The processing main block (20-C) first includes three data generators (26-1 to 26-3), that are designed to be very fast from a circuit point of view. The three data generators prepare the STDATA and STRW signals to be used on a following cycle. It further includes three latch pairs (27-1 to 27-3), one for each data generator, to output the STDATA and STRW signals one cycle later Finally, the STDATA signals are stored in two latch pairs (28-1, 28-2) to generate the corresponding EXDATA signals one cycle later.

## Description

The invention relates to integrated circuits of the memory type, such as stand-alone SRAMs or logic arrays with embedded SRAM macros, provided with built-in self-test capabilities for logic and memory fault detection and fabricated in semiconductor chips. It more particularly relates to a new processor-based ABIST (Array Built-in Self-Test) circuit. As memories get faster, more complex, and denser, there is an increasing demand on ABIST structures offering high speed and high test coverage, while consuming minimal area on the semiconductor chip.

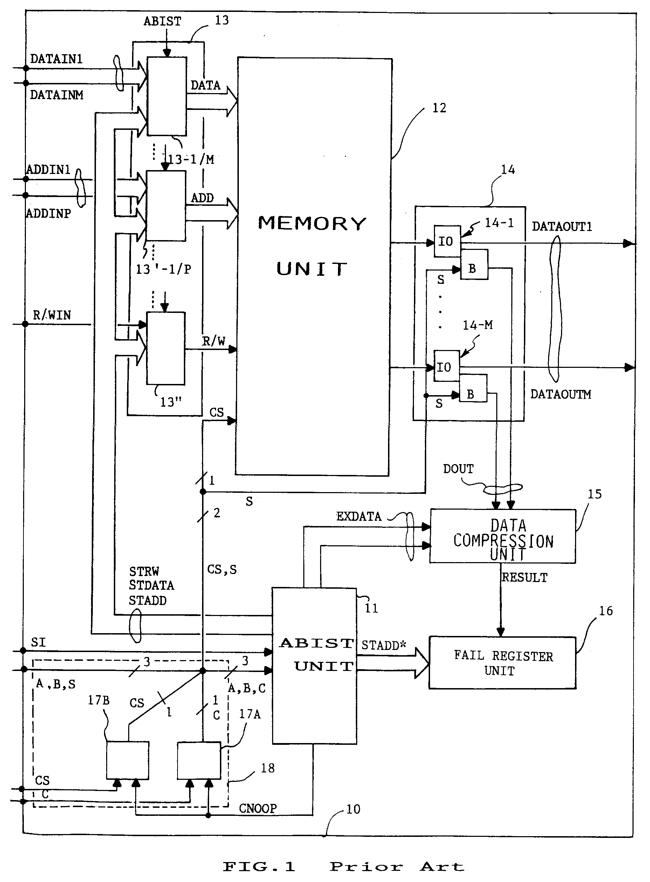

For sake of illustration, Fig. 1 shows the block diagram architecture of a state of the art SRAM macro 10 provided with an ABIST unit 11. A similar architecture is described in Ref. D1: US-A-5 173 906 assigned to the assignee of the present invention. The functional units shown in Fig. 1, either form a part of a stand-alone SRAM or the SRAM macro of a logic array of an integrated circuit chip. In the latter case, the chip may include a plurality of such macros, each being provided with its own dedicated ABIST unit. The said integrated circuit chip is part of a wafer fabricated in a very large scale integration (VLSI) semiconductor technology and is designed according to level-sensitive scan design (LSSD) rules.

As known for those ordinary skilled in the art, the SRAM macro 10 of Fig. 1 has three basic operating modes. The first one is the SYSTEM mode, according to which the SRAM macro 10 is in normal operation, i.e. where the memory unit 12 is either read or written, using the data-in signals DATAIN1 to DATAINM, the SRAM address signals ADDIN1 to ADDINP, and the read/write control signal R/WIN (wherein M and P are the respective bit widths of the data-in bus DATAIN and the SRAM address bus ADDIN). The second mode is required because of the LSSD construction: the SCAN mode which is used for initializing/analyzing (SCAN-IN/SCAN-OUT) all the data of the latch pairs, which are used extensively in the SRAM macro architecture of Fig. 1, to form the LSSD chain. Finally, the third mode is the ABIST mode, in which the memory unit 12 functionality is tested. It is a self-test which is first performed in the manufacturing environment, before the chip is commercially released. A slightly different, more relaxed self-test is performed while the chip is incorporated in a system, for example at the customer location, and thus in the system environment. As a result, the ABIST mode is used in different environments referred to hereinbelow as the ABIST mfg sub-mode and the ABIST system sub-mode.

In the ABIST mode, according to the fundamentals of the self-test technique, the ABIST unit 11 generates a plurality of test pattern sequences. Each test pattern consists of a set of deterministic one's and zero's that are first written into the memory unit 12, then read out and compared with the expected pattern. Said test pattern sequences have thus the key role of exercising the memory unit 12 in order to verify, with a given precision, whether or not the memory unit 12 under test is properly functioning, i.e. to determine whether the READ and WRITE operations have been successful or not. To that end, the ABIST unit 11 generates self-test data signals STDATA, self-test address signals STADD, and the self-test read/write control signal STRW.

Three groups of multiplexers have the role of selecting the signals to be fed in the memory unit 12, i.e. either the external signals mentioned above coming from outside the SRAM macro 10, i.e. the DATAIN1 to DATAINM, ADDIN1 to ADDINP, and R/WIN signals, or the internal self-test signals generated by the ABIST unit 11 mentioned above i.e. the STDATA, STADD, and STRW signals. In Fig. 1, the multiplexers forming these three groups are respectively referenced 13-1 to 13-M, 13'-1 to 13'-P, and 13''. The selection is made under the control of the ABIST control signal. Usually, when the ABIST signal is held at the logic "0", the external signals are selected and when held at the logic "1", the signals that are internally generated by the ABIST unit 11 are selected. The ABIST signal thus allows the SRAM macro 10 to operate either in the SYSTEM mode or in the ABIST mode. The said three groups of multiplexers, i.e. 13-1 to 13-M, 13'-1 to 13'-P, and 13'' form multiplexer block 13. The outputs of the first and second groups are labelled DATA bus and ADD bus, with M and P respective bit widths. The output of multiplexer 13'' is a single wire which transports the R/W control signal which determines the READ/WRITE operating mode of memory unit 12.

The data-out signals that are output by the memory unit 12 are stored in a battery of data-out L1/L2 latch pairs referenced 14-1 to 14-M forming the data-out shift register unit 14. Generally, these data-out latch pairs are incorporated in the memory unit 12. The data-out signals that are output by the L1 and L2 latches are labelled DATAOUT1 to DATAOUTM (DATAOUT bus) and DOUT1 to DOUTM (DOUT bus) respectively. In the ABIST mode, after a READ operation has been performed, expected data signals labelled EXDATA are generated by the ABIST unit 11 on the EXDATA bus and compared in the data compression unit 15 with the data-out signals DOUT1 to DOUTM. Typically, only four test patterns are used on each word of the memory unit 12: alternate zero's and one's, i.e. 0101...01 and 1010...10), all zero's and all one's. In others words, there are only four self-test data signals, labelled STDATA0, STDATA1 and their respective complements. Because of the particular structure of these four test patterns, the data-out signals DOUT1 to DOUTM are divided into even and odd data-out signals. The even data-out signals that are output from the data-out shift register unit 14 are labelled DOUT2, DOUT4,..., DOUT2j, and similarly, the odd data-out signals are labelled DOUT1, DOUT3,..., DOUT(2j-1), where j is an integer equal to M/2, assuming M is an even number. Therefore, as all the even and odd numbered bits of the data-out signals are at the same '0' or '1' value at the same time, only two expected data signals, each one consisting of a single bit, labelled EXDATA0 and EXDATA1 are required. For instance, assuming the data-out signals to be read on the DOUT bus are: 010101...01, the expected data signal EXDATA0 (for the even numbered bits) will be "1" and the expected data signal EXDATA1 (for the odd numbered bits) will be "0". Said EXDATA0 and EXDATA1 signals are thus the expected results for the even and odd data-out signals respectively. Finally, data compression unit 15 generates a signal labelled RESULT which is held at a high logic level, i.e. the "1" logic state, if there is a mismatch during the comparison. By mismatch, it is meant that at least one data-out signal does not have the same logic value as its corresponding even or odd expected data generated by the ABIST structure 11. This mismatch is often caused by a defective word line in the memory unit 12 at a determined address. This mismatch is usually referred to as a "fail". On the contrary, if all data-out signals match with the corresponding even or odd expected data signals (which means no fail is detected), then the RESULT signal is held at the low logic level, i.e. the "0" logic state. The RESULT signal, which is often referred to in the literature as the FAIL FOUND LAST CYCLE signal, indicates after a READ operation, whether the memory unit 12 at the current address being tested, is defective or not. The RESULT signal is therefore indicative of the fail/no fail status of memory unit 12, on a cycle by cycle basis. Another key component of the state of the art SRAM macro 10 is the fail register unit 16. It is required because, in the ABIST mfg sub-mode, the addresses of the defective word lines have to be identified, then memorized for subsequent use in the SYSTEM mode. When the RESULT signal is raised to a logic "1", indicating thereby existence of a fail, the word portion of the current address generated by the ABIST unit 11 on the STADD bus, labelled STADD*, is stored in a bank of latch pairs of this fail address register unit 16. This stored word address thus corresponds to the address of a defective word line.

The ABIST unit 11 also generates a CNOOP (NOOP stands for NO OPERATION) signal to inhibit the ABIST self-test mode, when the totality of the test pattern sequences has been fully exercised on the memory unit 12. This signal is absolutely required when there is a plurality of SRAM macros embedded in a single semiconductor chip. Said macros may have different sizes thus requiring different durations for their respective test. The CNOOP signal generated by the ABIST unit of each SRAM macro allows the memory units of all macros to be simultaneously tested.

The general clocking of SRAM macro 10 is achieved as standard in accordance with LSSD rules. In the state of the art architecture of the SRAM macro 10 illustrated in Fig. 1, the clocking would be normally implemented by standard external LSSD clock signals labelled A, B, C, and S, and by the CS (CHIP SELECT for a stand-alone SRAM chip or ARRAY SELECT for a SRAM macro) signal. Note that the S clock signal, which is substantially the same as the B clock signal, is applied to the L2 latches of latch pairs 14-1 to 14-M of data-out shift register unit 14. In the ABIST mfg sub-mode, the clock and CS signals are derived from the tester. In the ABIST system sub-mode, these signals are derived from the system clock. The SCAN-IN (SI) signal is applied to the ABIST unit 11 according to the standard LSSD rules, as illustrated in Fig. 1. However, for sake of simplicity, the SCAN-OUT signal generated by the ABIST unit 11 in response to the SCAN-IN signal, to be applied as the SCAN-IN signal to the next latch pair, and so on, along the whole LSSD chain, has not been represented. In the following description, only latches will be mentioned while it is clear, that according to the LSSD concept, they are latch pairs in reality. All these signals are directly applied to the ABIST unit 11 and/or the memory unit 12, except the C clock and CS signals. The C clock signal is applied to one input of 2-way AND gate 17A. The CS signal is applied to one input of 2-way AND gate 17B. The CNOOP signal is applied to the other input of these AND gates 17A and 17B as a gating signal, in order to block, when needed, the transmission of the respective C clock and CS signal. This occurs when the self-test has been completed in the ABIST mode, and permanently in the SYSTEM mode. The A, B, and S clock signals are used during the SCAN mode, and the B, C, S and CS signals are used during the ABIST mode. The CS signal is used alone in the SYSTEM mode, and the LSSD clock signals are held in a non-active state. Numeral 18 schematically illustrates the clock distribution scheme in the SRAM macro 10 and also includes the internal chip clock distribution network servicing it. This terminates the description of a state of the art SRAM macro provided with an ABIST structure.

The previous ABIST unit described in Ref. D1 is essentially organized around a state machine approach for determining self-test data and self-test read/write stimuli on a cycle by cycle basis. According to said previous ABIST unit, the generation of the self-test data STDATA, self-test address STADD, and the self-test read/write STRW signals, implies the use of a large amount of combinational logic circuits, because it is based on a hard-coded mechanism. Moreover, this mechanism is known to be relatively slow and has limited programmability. As a result, a much greater complexity in the state machine logic circuitry would be required to meet the present demand (expected to grow in the future) for the ABIST self-test of high speed SRAM macros with ever decreasing memory access times. The conventional state machine based unit described in the above cited reference has typically a system cycle time of about 10-13 ns for a SRAM macro designed in an advanced CMOS technology, and implies nine logic levels in the data generation and the state machine logic circuitry, leading to a total of about 200 logic gates. This large number of logic gates not only unfavorably impacts the memory access time measurement and ABIST cycle time, but also results in an excessive consumption of the semiconductor chip surface. Consequently, today, there is a strong need for developing new ABIST structures wherein the above mentioned intrinsic limitations or drawbacks are overcome.

Therefore, it is a primary object of the present invention to provide a novel processor-based ABIST circuit that is fully compatible with the previously known state machine based ABIST units and can advantageously be implemented in high speed SRAM macros.

It is another object of the present invention to provide a novel processor-based ABIST circuit adapted to the test of high speed SRAM macros with short memory access times.

It is another object of the present invention to provide a novel processor-based ABIST circuit adapted to the test of high speed SRAM macros having a minimum system cycle time.

It is another object of the present invention to provide a novel processor-based ABIST circuit offering reduced complexity in terms of logic circuit integration and a significant macro size reduction.

It is still another object of the present invention to provide a novel processor-based ABIST circuit that has a high programmability.

It is still further another object of the present invention to provide a novel processor-based ABIST circuit that is adaptable to any SRAM macro architecture.

These objects will be accomplished, in particular, by an integrated circuit, such as a SRAM macro, which includes a processor-based ABIST circuit according to claim 1.

In contrast to the conventional state machine based ABIST unit described in Ref. D1, that is essentially based on hard-coded pattern generated self-test data whose implementation requires nine logic levels and thus the use of a large amount of combinational logic circuits, the new structure relies upon a processor-based ABIST circuit performing repetitive operations on programmable data. The novel processor-based unit of the present invention requires a fewer number of logic levels with regards to the said conventional structure, and thus leads to a significant reduction of the number of combinational logic circuits.

From a hardware point of view, this processor-based ABIST circuit basically comprises three main blocks: a conventional address generator block, a specific control logic block generating control signals, and finally, an innovative processing block driven by said control signals which represents the core of the processor-based ABIST circuit of the present invention.

The conventional address generator block generates the CNOOP, STADD, and the STBA0E and STWA0E (self-test bit and word address signals that are used to generate the LSB's on the following cycle) signals as standard, but the two latter signals will be used in the control logic main block which is considered to be new. The role of the control logic main block is to force a proper signal sequencing of the processing main block during the ABIST mode, at every memory address. To that end, it generates four control signals TS0, TS1 and their complements CTS0 and CTS1. Control signals are determined by the type of test patterns and the ABIST cycle. Processing main block has the key role of generating the STDATA, the EXDATA, and the STRW signals, in response to the said control signals. The processing main block first includes three data generators. Each data generator is essentially composed of four LSSD scan-only latches (that are initialized during the SCAN mode) forming a table of data sub-block and a 4 to 1 multiplexer sub-block. The multiplexer sub-block selects one of the four scan-only latch outputs and is controlled by a logic combination of the said four control signals. The data generators are designed to be very fast from a circuit point of view. The processing main block further includes three latch pairs, one for each data generator, to capture the signals that are are output by the multiplexer sub-block, for subsequent release during the following cycle. The signals that are output from the data generators, are referred to as the OROUT signals. The two first OROUT signals are stored into the two first latch pairs, to generate the STDATA signals. The third OROUT signal is stored in the third latch pair to generate the STRW signal. Finally, the STDATA signals are stored in two latch pairs to generate the corresponding EXDATA signals.

Therefore, according to the basic principles of the present invention tables of data are first initialized during the SCAN mode. Next, these tables of data are multiplexed every cycle during the ABIST mode. The multiplexage of the self-test data and the self-test read/write signals is performed processing main block underthe control of the control logic main block.

The features believed to be characteristic of this invention are set forth in the claims. The invention itself, however, as well as other objects and advantages thereof, may be best understood by reference to the following detailed description of an illustrated preferred embodiment to be read in conjunction with the accompanying drawings.

Fig. 1 shows the partial schematic view of the block diagram architecture of a state of the art SRAM macro including an ABIST unit.

Fig. 2 shows the schematic block diagram of the processor-based ABIST circuit of the present invention including three main blocks, to be implemented in the ABIST unit of the SRAM macro of Fig. 1.

Fig. 3 shows circuit details of the control logic main block of the processor-based circuit of Fig. 2.

Fig. 4 shows circuit details of one the three data generators which are an essential part of the processing main block of the processor-based circuit of Fig. 2.

Fig. 5 shows waveforms of the essential signals to illustrate operation of the processor-based ABIST circuit of Fig. 2 in the ABIST mode.

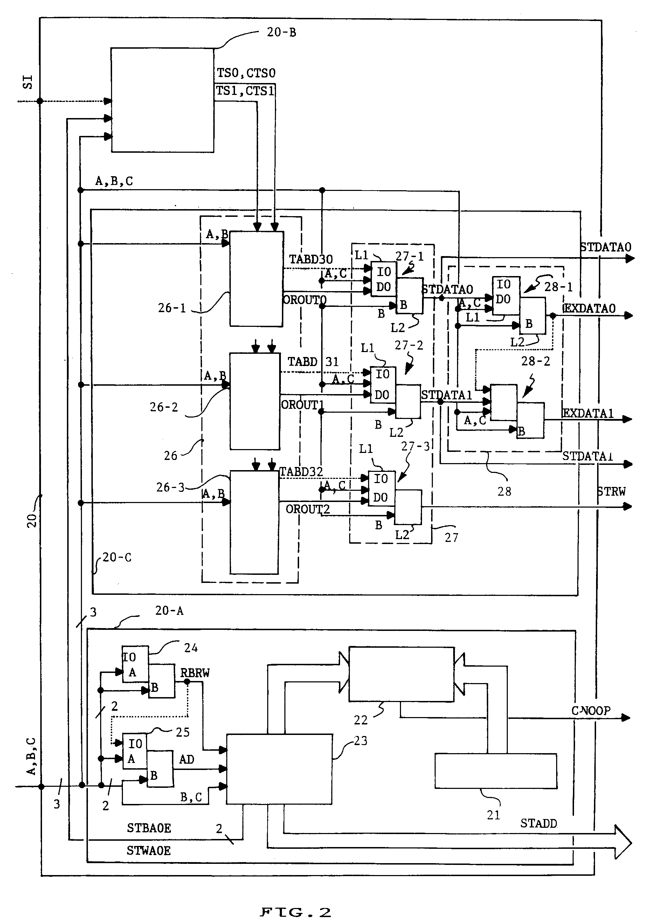

Note that for sake of simplicity, in Figs. 2 to 4 the various SCAN-IN/SCAN-OUT signals have been either not represented or are shown in dotted lines. Because these interconnections are proper to the LSSD construction, they thus fall within the scope of the man ordinary skilled in the art.

Fig. 2, illustrates the major elements of the processor-based ABIST circuit 20 that will play the role of ABIST unit 11 of Fig. 1 according to the present invention. The processor-based ABIST circuit 20 consists of three main blocks: a conventional address generator block 20-A, a control logic block 20-B which forces a proper ABIST sequencing of circuit 20, and an innovative processing block 20-C.

Address generator main block 20-A is the addressing section of circuit 20. As standard, it generates the STADD (self-test address), the STBA0E (self-test bit address 0 early) and STWA0E (self-test word address 0 early) signals, and finally, the CNOOP signal. The CNOOP signal is a gating signal that flags the end of the ABIST mode in the testing of the memory unit 12, by gating AND gates 17A and 17B in Fig.1.

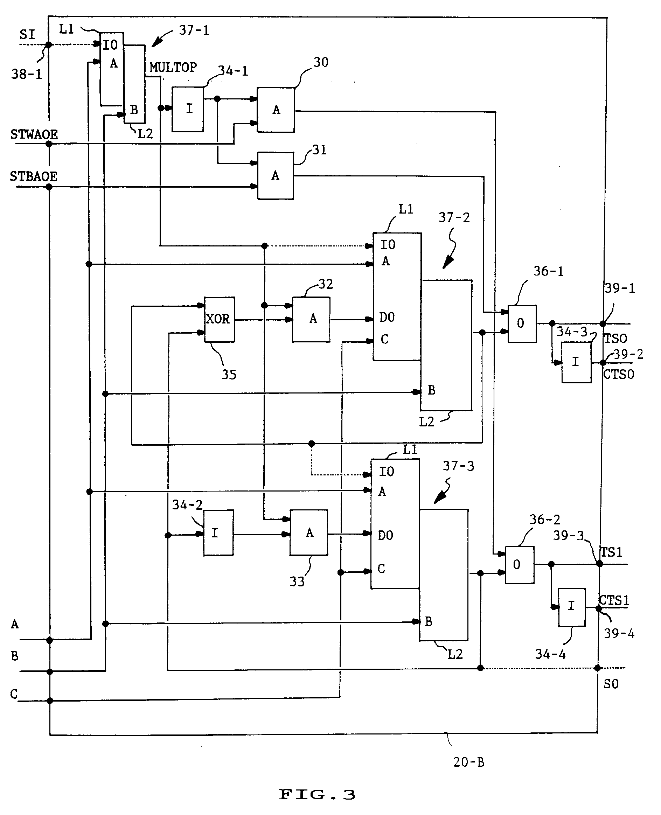

Main block 20-A first includes: a register 21 containing the maximum address, an address comparator 22, and a high speed synchronized up/ down counter 23 that can be programmed to use the bit address or the word address as the LSB, when counting through the address space. It further includes two L1/L2 latch pairs referenced 24 and 25 to supply the RBRW (Ripple Bit Ripple Word) and the AD (ADDRESS DECREMENT) signals respectively to the up/down counter 23. In essence, main block 20-A operates as an incrementer/decrementer which can have either a bit address or a word address as its LSB. The AD and RBRW signals are initialized during the SCAN mode. The AD signal controls whether the counter increments or decrements. The RBRW signal controls whether the LSB of the counter is a bit address or a word address. The address counter changes either every cycle or every four cycles depending on the data initialized in the latch pair 37-1 which generates the MULTOP signal, as it will be explained later on, in conjunction with Fig. 3. The STADD bus conveys the STADD signals that control the memory unit 12 addressing during the ABIST mode. Signals STBA0E (self-test bit address 0 early) and STWA0E (self-test word address 0 early) are two early addresses. In conventional ABIST units, these signals were only internally used in address generator main block 20-A, but now according to the present invention, they also are sent to the control logic main block 20-B. The CNOOP signal is activated as soon as the address counter 23 has reached the maximum address when incrementing (or the zero address when decrementing). This CNOOP signal appears when the test pattern sequence has been fully exercised during the ABIST mode and acts as a gating signal as mentioned above. Address counter 23 will automatically stop address sweeping as soon as the whole address space has been swept. Note that, main block 20-A is considered to be state of the art, since this architecture is of current use in the conventional ABIST structures, e.g. in the state of the art ABIST unit described in Ref. D1 mentioned above.

Control logic main block 20-B is the control signal generator section of circuit 20. It is driven by said STBA0E and STWA0E signals generated by the address generator main block 20-A. It is designed to deliver four control signals labelled TS0, TS1, and their respective complements CTS0 and CTS1. These four control signals are essential to the operation of the processing main block 20-C and in particular, to the operation of the data generator labelled 26-1 to 26-3 contained therein. This main block 20-B will be more detailed by reference to Fig. 3.

Still by reference to Fig. 2, processing main block 20-C is the self-test data STDATA, expected data EXDATA, and self-test read/write STRW signal generator section of circuit 20. Functionally, this block generates the STDATA signals for writing into the memory unit 12, as well as the EXDATA signals used to verify that the values that are output from the memory unit 12, via data-out shift register unit 14 and data compression unit 15 (see Fig. 1), are correct. Finally, main block 20-C generates the STRW signal to control whether or not the memory unit 12 is in a READ or WRITE operating mode. The essential part of main block 20-C consists of three data generators 26-1 to 26-3, which together form block 26. The signals that are output therefrom, respectively referred to as the OROUT0 to OROUT2 signals, are delayed by one cycle, using three latch pairs 27-1 to 27-3, which together form block 27. The two first latch pairs 27-1 and 27-2 generate the STDATA i.e. the STDATA0 and STDATA1 signals. The third latch pair 27-3 generates the STRW signal. In turn, The STDATA signals are latched in latch pairs 28-1 and 28-2 which together form block 28, to generate the EXDATA i.e. EXDATA1 and EXDATA2 signals.

Main block 20-B will be now considered by reference to Fig. 3, which shows the detailed circuit construction thereof. Turning to Fig. 3, control logic main block 20-B is composed of four 2-way AND gates 30 to 33, four inverters 34-1 to 34-4, one 2-way exclusive OR (XOR) gate 35, two 2-way OR gates 36-1 and 36-2, one L1/L2 scan-only latch pair 37-1 and two L1/L2 regular latch pairs 37-2 and 37-3. Each regular batch pair is composed of an L1 latch and an L2 latch. The L1 latch of each regular latch pair has an I0 input, and an A clock input which allows the data at the I0 input to be captured. In addition, the L1 latch has a D0 input, and a C clock input that allows the data at the D0 input to be captured. The scan-only latch pair has an identical construction with regard to the regular latch pair except in that, its L1 latch is not provided with the D0 and C inputs. The L2 latch of the scan-only and regular latch pairs have a B clock input that allows the data to be transferred from the L1 latch to the L2 latch. The L2 latch of the scan-only and regular latch pairs have an output that has the same logic value as the data contained in the L2 latch. Note that, the three latch pairs 37-1 to 37-3 are connected in a LSSD scan chain as standard. The input signals that are applied to main block 20-B are: the SCAN-IN signal (SI), the A, B and C clock signals that are externally generated, and finally, the two signals labelled STWA0E and STBA0E, that are generated in the address generator main block 20-A of Fig.2. The signals that are output are labelled TS0, TS1 and their respective complements CTS0, CTS1. In Fig. 3, the input and output terminals are generically referenced 38 and 39 respectively.

The SI signal is applied to the IO input of latch pair 37-1. The output of latch pair 37-1 is connected to the I0 input of L1 latch of latch pair 37-2, the input of inverter 34-1, and the first input of AND gates 32 and 33. The output of inverter 34-1 is connected to the first input of AND gates 30 and 31. The STWAOE and STBAOE signals are respectively applied to the second input of AND gates 30 and 31. The second input of AND gate 32 is connected to the output of XOR gate 35 and the second input of AND gate 33 is connected to the output of inverter 34-2. The first and second inputs of the XOR gate 35 are connected to the output of latch pairs 37-2 and 37-3 respectively. Note that, the signal output by latch pair 37-3 is a typical example of the so-called SCAN-OUT (S0) signals which play an important role in LSSD designed circuits as known by those skilled in the art. The input of inverter 34-2 is also connected to the output of latch pair 37-3. The first and second inputs of OR gate 36-1 are connected to the output of AND gate 31 and to the output of the latch pair 37-2 respectively. The output of OR gate 36-1 supplies the control signal TS0 at terminal 39-1 and its complement CTS0 via inverter 34-3 at terminal 39-2. The first and second inputs of OR gate 36-2 are connected to the output of AND gate 30 and to the output of the latch pair 37-3 respectively. Similarly, the output of OR gate 36-2 supplies the control signal TS1 at terminal 39-3 and its complement CTS1 via inverter 34-4 at terminal 39-4. As apparent from Fig.3, the A and B clock signals are applied to the scan-only latch pair 37-1, and the A, B, and C clock signals are applied to the regular latch pairs 37-1 and 37-3, as standard. The MULTOP signal that is generated at the output of latch pair 37-1, controls the functional mode of the control logic main block 20-B, depending on its logic value. In the ABIST mode, main block 20-B has two operating modes: the single operation sub-mode and the multiple operation sub-mode. In the single operation sub-mode, the MULTOP signal is low, control signals TS0 and TS1 have then the same logic values as the ones defined by the STWA0E and STBAOE signals respectively. Only AND gates 30 and 31 are operative in this sub-mode. In the multiple operation sub-mode, the MULTOP signal is at the high level, and signals TS0 and TS1 are counted in a modulo 4 fashion. In this sub-mode, the two latch pairs 37-2 and 37-3, and their related logic circuitry are operative. The MULTOP signal also controls wether the address counter 23 (see Fig. 2) changes its content every cycle or every four cycles. Finally, OR gates 36-1 and 36-2 make the appropriate selection between the said two sub-modes.

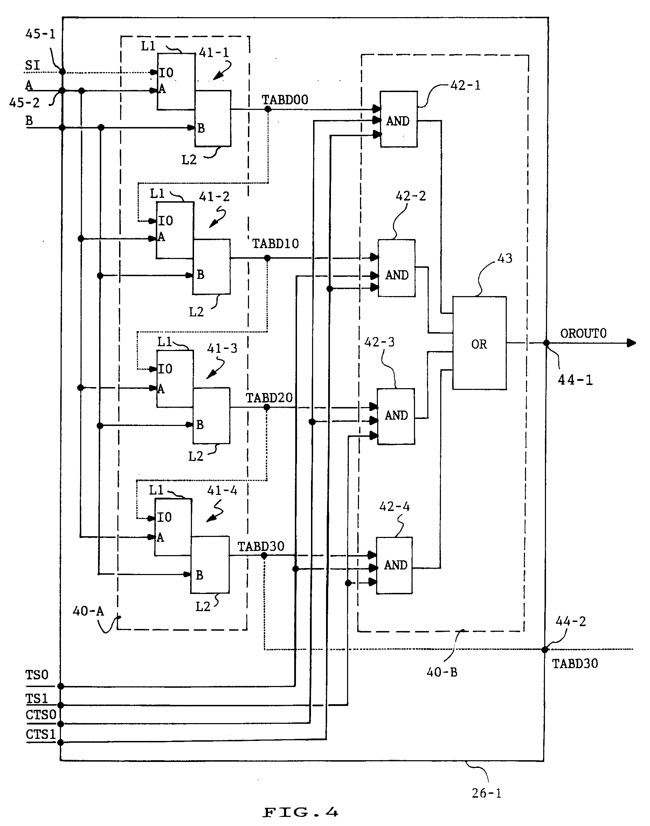

If we turn again to Fig. 2, the core of the processor-based ABIST unit 20 mainly lies in the processing main block 20-C, whose essential part consists of the three data generators 26-1 to 26-3 that have an identical structure, and which together form data generator block 26. Dta generators play a determining role in the table of data selection function. Detailed circuit construction of data generator 26-1 will now be described in conjunction with Fig. 4.

Now referring to Fig. 4, data generator 26-1 is composed of two sub-blocks 40-A and 40-B. Table of data sub-block 40-A comprises four LSSD scan-only latch pairs 41-1 to 41-4. Multiplexer sub-block 40-B is comprised of four 3-way AND gates 42-1 to 42-4 connected to a 4-way OR gate 43. Each one of the four scan-only latch pairs 41-1 to 41-4 contains a data for a single cycle. Control signals TS0, TS1 and their complements CTS0, CTS1, will choose which one of the four data will be sent to the memory unit 12 during the next cycle. The input signals of data generator 26-1 are the SCAN-IN signal (SI), the A, B clock signals and the said four control signals TS0, TS1, CTS0 and CTS1.

The SI signal is applied to the IO input of latch pair 41-1. The output of latch pair 41-1 (in fact, the L2 latch output), where signal TABD00 is available, is connected to the I0 input of latch pair 41-2. Likewise, the output of latch pair 41-2, where signal TABD10 is available, is connected to the I0 input of latch pair 41-3. In turn, the output of latch pair 41-3, where signal TABD20 is available, is connected to the I0 input of latch pair 41-4. The signal which is generated by latch pair 41-4 referenced TABD30 is output from data generator block 26-1 to be applied to the IO input of latch pair 27-1 as apparent from Fig.2. All these signals TABD00 to TABD30 essentially have an obvious SCAN-IN/SCAN-OUT function. The output of each latch pairs 41-1 to 41-4 is connected to the first input of the 3-way AND gates 42-1 to 42-4 respectively. The other two inputs of the said AND gates are connected to a determined combination of the said four control signals generated by logic control main block 20-B. As illustrated in Fig.4, AND gate 42-1 has for inputs: the TABD00 signal supplied by latch pair 41-1, the CTS0 and CTS1 signals. AND gate 42-2 has for inputs: the TABD10 signal supplied by latch pair 41-2, the TS0 and CTS1 signals. AND gate 42-3 has for inputs: the TABD20 signal supplied by latch pair 41-3, the CTS0 and TS1 signals. Finally, AND gate 42-4 has for inputs: the TABD30 signal supplied by latch pair 41-4, the TS0 and TS1 signals.

The output of each AND gates 42-1 to 42-4 is connected to the respective input of a four-way OR gate labelled 43 which performs the Boolean addition of the signals output by the said AND gates. The output terminal 44-1 of this OR gate 43, which delivers the OROUT0 signal, is connected to the D0 input of the regular latch pair 27-1 (see Fig. 2), according to an essential feature of the present invention.

As a final result, the combination of the four AND gates 42-1 to 42-4 and the OR gate 43 forming sub-block 40-B performs a multiplex function under the control of said four control signals. Sub-block 40-B selects which one among of the four TABDOO to TABD30 signals that are output from sub-block 40-A, is to be propagated to the D0 input of the regular latch pair 27-1 of Fig. 2. In other words, the signal applied to the D0 input of the regular latch pair 27-1 will have the same logic value as one of the four signals TABD00 to TABD30 generated by respective latch pairs 41-1 to 41-4.

The description of data generator 26-1 given by reference to Fig. 4, also applies to the other data generators 26-2 and 26-3 because they all have identical structures.

Now turning again to Fig.2, it can be noticed that said data generators 26-1, 26-2 and 26-3 generate intermediate output signals labelled OROUT0, OROUT1, OROUT2 and SCAN-IN/SCAN-OUT signals labelled TABD30, TABD31 and TABD32 respectively. Signals TABD30 and OROUT0 are respectively applied to the I0 and D0 inputs of latch pair 27-1. Still considering latch pair 27-1 for illustration purposes, the A and C clock signals are applied to the A and C inputs (not shown) of the L1 latch and the B clock signal is applied to the B input of the L2 latch as standard. The same reasoning applies to latch pairs 27-2 and 27-3. Latch pairs 27-1 to 27-3 have the role of storing the OROUT0 to OROUT2 signals, for one cycle, and together form storage delay block 27. Latch pairs 27-1 and 27-2 respectively supply the self-test data signals STDATA0 and STDATA1. Latch pair 27-3 supplies the self-test read/write stimuli signal STRW. The STDATA0 and STDATA1 signals are applied to respective D0 inputs of latch pairs 28-1 and 28-2. The output of latch 28-1 is connected to the I0 input of latch pair 28-2 as standard, because the two latch pairs are connected in a LSSD chain. Latch pairs 28-1 and 28-2, which together form the EXDATA generator block 28, respectively supply the EXDATA0 and EXDATA1 signals. The STDATA0 and STDATA1 signals are also output from processing block 20-C for subsequent use as apparent from Fig. 2. Finally, five signals are output from processing block 20C: STDATA0 and STDATA1 (STDATA), EXDATA0 and EXDATA1 (EXDATA), and STRW.

In main block 20-C of Fig. 2, data generators 26-1 to 26-3 have the determining role to ensure the 4 to 1 multiplexage, to generate the self-test data STDATA, and self-test read/write STRW signals that are required if there is a maximum of four operations for every address. However, this can be readily generalized to an N to 1 multiplexage of these signals, so that it would be possible to perform N operations per address. The table data initialization is completed during the SCAN mode thanks to the standard LSSD construction of main block 20-C. After the SCAN mode has been completed, the processor-based ABIST circuit 20 will be able to perform the programmed pattern at a very high speed by simply choosing the correct data from the table. After one full address sweep has been performed on the memory unit 12, in an incrementing or in a decrementing fashion, the processor-based ABIST circuit 20 will have exercised the test patterns in the memory unit 12 at every address, from the zero address to the maximum address that was initialized during the SCAN mode as mentioned above. Again, in the SCAN mode, a new initialization is then performed and the latch pair data analyzed.

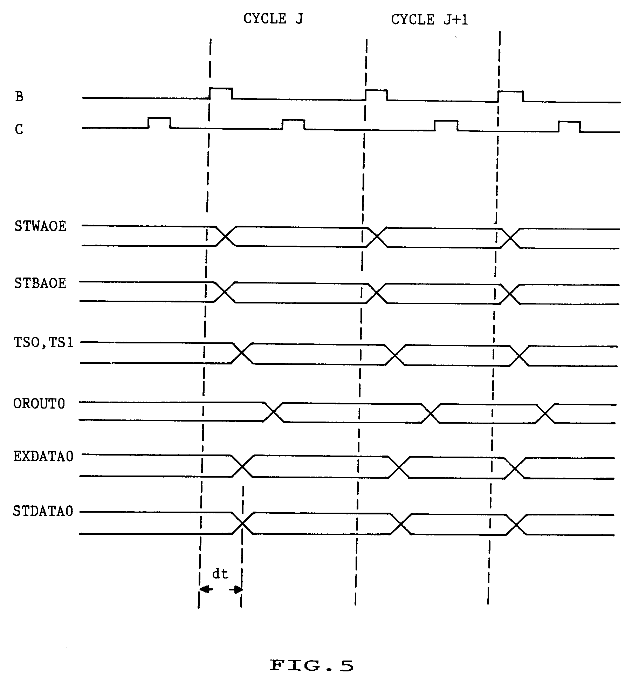

Now the operation of the processor-based ABIST circuit 20 of the present invention will be best understood by reference to the timing curves illustrated in Fig. 5.

Fig. 5 shows in detail the timing waveforms of the clock, control and data signals for the processor-based ABIST circuit 20 of the present invention in the ABIST mode. Fig. 5 depicts two successive cycles denominated cycle J and cycle J+1. Shown below the B and C clock signals, are the STWA0E, STBA0E address signals, the TS0, TS1 control signals, and the OROUT0, EXDATA0, STDATA0 data signals. The C clock signal is used to capture data into all the L1 latches of all the regular latch pairs of proceessor-based ABIST circuit 20, but it does not trigger any of the signal transitions shown in Fig. 5. When the B clock signal rises, the data in the L1 latch of each L1/L2 latch pair, is allowed to propagate to the L2 latch output, and at this time, signals illustrated in Fig.5 can change values. The delay between the rising edge of the B clock signal and the transition of a particular address, control, or data signal is a function of the delay in the processor-based ABIST circuit 20. For example, OROUT0 signal has a transition later than TS0, as a result of the extra delays caused by the two logic levels of sub-block 40-B (Fig. 4). It will be understood that the exact placement of the different address, data and control signals depicted in Fig. 5, for a particular processor based ABIST circuit depends upon the specific parameters of the design system and the manufacturing process involved. Selection of these exact quantitative timings is well within the perview of one ordinary skilled in the art.

The processor-based ABIST circuit 20 of the present invention has greater flexibility in terms of programmability than the state machine of Ref. D1. This is illustrated by the following example. If a new test pattern is necessary to detect a fail that was not detected during a first pass, processor-based ABIST circuit 20 can be reprogrammed with new test patterns late in the manufacturing cycle. This is achieved by mere changes to the test pattern initialization which was not previously possible. Another advantage of the processor-based ABIST circuit of the present invention, with respect to the state machine approach of the prior art, is its design simplicity, which will result in a reduced number of design errors. With the said conventional state machine approach of Ref D1, designing many custom logic books would have been required to meet the short system cycle time that are now required for present high speed SRAM macros. By adopting the processor-based approach of the present invention, the highly desired short cycle times can be obtained without designing said custom logic books.

The conventional state machine based ABIST unit of Ref. D1 requires a lot of combinational logic circuitry to generate each hard-coded test pattern, and a large sequencer that sequentially steps therethrough. As a result, the data generation requires a large number of logic circuit levels (9 levels) due to all the control logic and the large number of internal signals to be taken into account. Compared with the conventional ABIST unit of Ref. D1, implementation of the proccessor-based ABIST circuit 20 of the present invention, in a standard CMOS technology, would have reduced the macro size, by at least 50%, saving thereby a significant area in the semiconductor chip surface. In addition, the self-test data is now generated in about 2.1 ns (illustrated by delay dt in Fig.5) as opposed to approximately 6.3 ns obtained by the conventional ABIST unit of Ref. D1. In the future, new ABIST structures will be designed to run at short system cycle times of about 5ns or less.

Moreover, unlike the conventional state machine based ABIST units, the novel processor-based ABIST circuit of the present invention can be programmed for each task such as a "write 0 blanket pattern", or a "read complement checkerboard pattern", and the like without any limitation. As a result, all the test patterns that were generated with the conventional state machine based ABIST units, are still available, as well as an assortment of new programmable test patterns. Finally, the processor-based ABIST circuit 20 can fit any conventional ABIST structure of the state machine type.

In summary, the advantages of the architecture of the processor-based ABIST circuit of the present invention are: faster data generation, reduced complexity for minimal semiconductor area consumption, extended programmability, and full compatibility.

Although the present invention has been described for SRAM macros, the processor-based ABIST circuit 20 may find large applications in DRAMs, flash memories ...etc, and in stand-alone chips as well.

## Claims

1. An integrated circuit incorporating at least one SRAM macro (10) of the type including:
an ABIST unit (11) for generating self-test data (STDATA), self-test address (STADD), expected data (EXDATA), self-test read/write (STRW) and gating (CNOOP) signals;
a memory unit (12) responsive to said self-test data, self-test address, and self-test read/write signals in the ABIST mode to generate data-out (DOUT) signals;
a data compression unit (15) for comparing said data-out signals output by the memory unit with the expected data (EXDATA) signals to generate a signal (RESULT) that is indicative of the fail/no fail status of the memory unit on a cycle by cycle basis;
a fail register unit (16) to store the defective memory addresses; and,
a clock and control signal generating means (18,...) to generate the LSSD clock (A, B, C) signals for a proper sequencing of the SRAM macro and control signals (ABIST,...) to select the ABIST mode;
chracterized in that said ABIST unit consists of a processor-based ABIST circuit (20) comprising:
- address generator means (20-A) generating the CNOOP, the self-test address (STADD), and the self-test bit address 0 early (STBA0E) and self-test word address O early (STWA0E) signals;
- control logic means (20-B) generating control signals (TS0,CTS0,...) to force a proper sequencing of the processor-based ABIST circuit; and,
- processing means (20-C) consisting of:
- a plurality of data generators (26-1, ...) driven by the LSSD clock signals (A, B,...) under the control of said control signals to generate a plurality of intermediate output signals (OROUT0, ...) that prepare the STDATA and STRW signals to be used on a following cycle;
- a corresponding plurality of latch pairs (27-1, ...) to store the said intermediate output signals to generate the STDATA and STRW signals;
- a number of latch pairs (28-1, ...) corresponding to the number of said STDATA signals to store the STDATA signals and to generate the EXDATA signals on the following cycle.

2. The integrated circuit of claim 1 wherein each of said data generator (26-1)consists of:
a table of data sub-block (40-A) formed by a plurality of scan-only latch pairs (41-1, ... ) connected in a LSSD chain, whose L1 and L2 latches are respectively driven by said LSSD clock signals; and,
a multiplexer sub-block (40-B) formed by:
a corresponding plurality of AND gates (42-1, ...), each being gated by a combination of said control signals, and driven by the signal that is output by the corresponding latch pair of the table of data sub-block; and,
an OR gate (43) to perform the boolean addition of the plurality of signals that are output by said AND gates to generate the coreponding intermediate output signal (OROUT0).
